Europäisches Patentamt

European Patent Office

Office européen des brevets

(11) Veröffentlichungsnummer: **0 339 741**

**A2**

(12) # EUROPÄISCHE PATENTANMELDUNG

(21) Anmeldenummer: 89201060.4

(22) Anmeldetag: 24.04.89

(51) Int. Cl.4: **H01L 21/20 , H01L 29/86 , G01L 9/04 , H01C 8/02**

(30) Priorität: 28.04.88 DE 3814348

(43) Veröffentlichungstag der Anmeldung:
02.11.89 Patentblatt 89/44

(84) Benannte Vertragsstaaten:
**DE FR GB NL**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB NL**

(72) Erfinder: **Graeger, Volker, Dr.**
**Hochkamp 10a**
**D-2110 Buchholz(DE)**
Erfinder: **Kobs, Rolf**
**Kastanienring 5**
**D-2082 Tornesch(DE)**
Erfinder: **Schäfer, Horst**
**Am Felde 37**
**D-3510 Hannoversch Münden(DE)**
Erfinder: **Zeile, Heinrich Dr.**
**Flurstrasse 32**
**D-2000 Hamburg 53(DE)**

(74) Vertreter: **Nehmzow-David, Fritzi-Maria et al**
**Philips Patentverwaltung GmbH**
**Wendenstrasse 35 Postfach 10 51 49**
**D-2000 Hamburg 1(DE)**

(54) **Verfahren zur Herstellung einer polykristallinen halbleitenden Widerstandsschicht aus Silicium auf einem Siliciumträger.**

(57) Die Erfindung bezieht sich auf ein Verfahren zur Herstellung einer polykristallinen halbleitenden Widerstandsschicht aus Silicium auf einem Siliciumkörper. Zuerst wird eine Isolierschicht auf dem Siliciumkörper erzeugt und anschließend eine polykristalline Siliciumschicht abgeschieden. Auf die abgeschiedene polykristalline Siliciumschicht wird eine weitere polykristalline Siliciumschicht mit einem gegenüber dem der ersten polykristallinen Siliciumschicht größeren Kristallitgefüge aufgebracht. Die beiden polykristallinen Siliciumschichten werden zusätzlich dotiert. Weiter bezieht sich die Erfindung auf einen Silicium-Druckaufnehmer mit einer derartigen Widerstandsschicht.

FIG.1

# Verfahren zur Herstellung einer polykristallinen halbleitenden Widerstandsschicht aus Silicium auf einem Siliciumkörper und Silicium-Druckaufnehmer mit einer derartigen Widerstandsschicht

Die Erfindung bezieht sich auf ein Verfahren zur Herstellung einer polykristallinen halbleitenden Widerstandsschicht aus Silicium auf einem Siliciumkörper, bei dem zuerst eine Isolierschicht auf dem Siliciumkörper erzeugt und anschließend eine polykristalline Siliciumschicht abgeschieden wird, die zusätzlich dotiert wird. Weiter bezieht sich die Erfindung auf einen Silicium-Druckaufnehmer mit einer derartigen Widerstandsschicht.

Ein solches Verfahren ist aus dem Aufsatz "Silizium-Drucksensor für hohe Betriebstemperaturen" von E. Obermeier und F. von Kienlin, Proc. Sensor '85, Transducer-Technik: Entwicklung und Anwendung, Karlsruhe 1985, Seiten 4.3.1 bis 4.3.12, bekannt. Hierbei wird eine Widerstandsschicht aus polykristallinem halbleitendem Silicium auf einen Druckaufnehmer aufgebracht, der aus einem Siliciumkörper besteht, welcher auf einem Träger angeordnet ist. Der Siliciumkörper hat einen sacklochartigen Hohlraum, wodurch eine Membran ausgebildet wird. Auf der Außenfläche der Membran ist die strukturierte Widerstandsschicht aufgebracht.

Bei der Herstellung der Widerstandsschicht wird auf der Membran durch thermische Oxidation eine Oxidschicht (Siliciumdioxid) als Isolierschicht erzeugt. Anschließend erfolgt eine Abscheidung einer polykristallinen Siliciumschicht durch Low Pressure Chemical Vapour Deposition (LPCVD) mit Silan als Reaktionsgas in einem üblichen Diffusionsofen. Danach wird die Schicht durch Ionenimplantation dotiert und die entstandene Widerstandsschicht nach einem thermischen Ausheilprozeß mittels eines Fotoätzprozesses strukturiert. Die Widerstandsschicht wird durch Aufdampfen und Strukturieren einer Aluminiumschicht kontaktiert. Die durch das thermische Ausheilen entstandenen Kristallite in der polykristallinen Schicht weisen einen mittleren Korndurchmesser von 80 nm bis 200 nm auf.

Das Maß für die Dehnungsempfindlichkeit eines Widerstandes R ist sein k-Faktor, der die relative Widerstandsänderung dR/R je Dehnung e angibt:

$$dR/R = k\,e.$$

Die nach obigem Verfahren hergestellte Widerstandsschicht weist einen k-Faktor zwischen 27 und 35 auf.

Statt eines Ausheilungsprozesses nach Abscheiden der polykristallinen Schicht, wie dies in der oben genannten Druckschrift vorgeschlagen wird, kann auch nach dem Abscheiden eine Laser-Rekristallisation zur Ausbildung vergrößerter Kristallite (Körner) verwendet werden, wie dies aus dem Aufsatz: "Laser-Recrystallized Polysilicon Resistors For Sensing And Integrated Circuits Applications" von J. Binder, W. Henning, E. Obermeier, H. Schaber und D. Cutter, Sensors and Actuators, 4, 1983, Seiten 527 bis 536, bekannt ist. Dabei wird die abgeschiedene polykristalline Siliciumschicht im Brennpunkt eines Lasers kurzzeitig aufgeschmolzen. Bei der Erstarrung des geschmolzenen Siliciums bilden sich vergrößerte Kristallite mit einem mittleren Korndurchmesser zwischen 1000 nm bis 10000 nm aus. Der k-Faktor für die mittels der Laser-Rekristallisation hergestellte polykristalline Schicht liegt zwischen 45 und 55. Es zeigt sich also, daß die Dehnungsempfindlichkeit der Widerstandsschicht von der Größe der Kristallite abhängt. Die Laser-Rekristallisation ist aber sehr aufwendig, da punktweise die gesamte Ober fläche der polykristallinen Siliciumschicht aufgeschmolzen werden muß. Um die Lichtenergie des Lasers in die Siliciumschicht einkoppeln zu können, muß das polykristalline Silicium außerdem durch eine zusätzliche transparente Nitridschicht abgedeckt werden, welche zur mechanischen Stabilisierung der flüssigen polykristallinen Schicht während der Laserrasterung und als Antireflexbelag dient, damit das Licht nicht von der Siliciumschicht reflektiert wird.

Der Erfindung liegt die Aufgabe zugrunde, ein auf einfache Weise zu realisierendes Verfahren zur Herstellung einer polykristallinen halbleitenden Widerstandsschicht aus Silicium auf einem Siliciumkörper zu schaffen, die einen k-Faktor von über 35 aufweist.

Diese Aufgabe wird bei einem Verfahren der eingangs genannten Art gemäß der Erfindung dadurch gelöst, daß auf die abgeschiedene polykristalline Siliciumschicht (erste polykristalline Siliciumschicht) eine weitere zu dotierende polykristalline Siliciumschicht mit einem gegenüber dem der ersten polykristallinen Schicht gröberen Kristallitgefüge aufgebracht wird.

Bei dem vorliegenden Verfahren dient die auf der Isolierschicht abgeschiedene polykristalline Schicht als Keimschicht für die weitere polykristalline Schicht. Die auf die Isolierschicht aufgebrachte Schicht kann feinkristallin und teilweise auch amorph sein. Bei der Abscheidung der weiteren polykristallinen Schicht in z.B. einem Epitaxie-Verfahrensschritt wird die polykristalline Schicht auf der Isolierschicht thermisch ausgeheilt und dient als Starthilfe zur Bildung größerer Kristallite in der weiteren polykristallinen Schicht.

Unter Epitaxie ist allgemein eine orientierte Kristallver- wachsung (vgl. Römpps Chemisches Wörterbuch, Deutscher TaschenbuchVerlag, München, 1974) und speziell das monokristalline Aufwachsen einer Schicht auf einem monokristallinen Substrat (vgl. D. Widmann, H. Mader, H. Friedrich, Technclogie hochintegrierter Schaltungen, Springer Verlag 1988) zu verstehen.Im vorliegenden Fall wird der Begriff Epitaxie in seiner allgemeinen Bedeutung verwendet.

Auf Schichten, die dem kristallinen Silicium nicht angepaßt sind, wie die Isolierschicht, findet bei einem epitaktischen Aufwachsprozeß ein grobkristallines Wachstum vereinzelter Kristallite statt, die nicht oder ungenügend miteinander verbunden sind. Dieses unzusammenhängende Entstehen von Kristalliten wird durch das Fehlen von geeigneten Aufwachsbedingungen verursacht.

Durch den Verfahrensschritt, eine polykristalline Schicht auf der Isolierschicht abzuscheiden, werden geeignete Kristalle für ein zusammenhängendes Wachstum größerer Kristallite geschaffen. Diese abgeschiedene Schicht bildet eine geschlossene Siliciumschicht, die weitgehend amorph ist oder aus sehr feinen Kristalliten besteht. Diese Schicht wird während des epitaktischen Aufwachsens der weiteren polykristallinen Schicht thermisch ausgeheilt. Es kommt also zu einer feinkristallinen Rekristallisation der Keimschicht. Während der Siliciumabscheidung durch Epitaxie finden die Siliciumatome genügend energetisch günstige Positionen, um sich an kristallisierte Bereiche der Keimschicht anzulagern. Da nicht alle Kristallorientierungen bei diesem Verfahren gleichmäßig schnell wachsen, setzen sich nur die bevorzugt wachsenden Orientierungen durch und es entsteht ein gröberes kristallines Gefüge. Der laterale mittlere Korndurchmesser der Kristallite liegt zwischen 1000 nm und 5000 nm. Der k-Faktor, das Maß für die Dehnungsempfindlichkeit dieser Widerstandsschicht, liegt zwischen 43 und 52.

Dieses erfindungsgemäße Verfahren ist also sehr viel einfacher auszuführen als das bekannte Verfahren der Laser-Rekristallisation und die nach diesem Verfahren hergestellte Widerstandsschicht weist einen ebenfalls hohen k-Faktor auf. Wie sich weiter herausgestellt hat, weist die erfindungsgemäße Widerstandsschicht eine ähnlich hohe Beweglichkeit wie einkristallines Silicium auf.

Vorzugsweise wird die polykristalline Siliciumschicht auf der Isolierschicht mittels Chemical oder Physical Vapour Deposition abgeschieden. Bei einer Abscheidung mittels Chemical Vapour Deposition bei niedrigem Druck (LPCVD) wird in einem üblichen Diffusionsofen die zu beschichtende Fläche einem Gasstrom ausgesetzt, der z.B. Siliciumtetrachlorid (SiCl₄) oder Silan (SiH₄) enthält. Das in dem Gas enthaltene Silicium scheidet sich an der zu beschichtenden Fläche ab. Die Abscheidung erfolgt bei Temperaturen zwischen 550 °C und 700 °C. Die Abscheidung erfolgt dabei bei einem Druck zwischen 0,1 mbar und 0,3 mbar, vorzugsweise bei einem Druck von 0,19 mbar. Sie sollte hierbei frühestens dann beendet werden, wenn sich eine dünne zusammenhängende Schicht ausgebildet hat. Nur dann sind nämlich die erforderlichen Wachstumsbedingungen für die größeren Kristallite der weiteren polykristallinen Schicht gegeben.

Die polykristalline Schicht kann auch mittels Kathodenzerstäubung (Sputtern) auf der Isolierschicht abgeschieden werden. Hierbei treffen hochenergetische Edelgasionen im Vakuum auf eine Kathode auf, die aus dem aufzustäubenden Material besteht, und setzen ungeladene Atome oder Moleküle frei, die sich auf dem Substrat (Siliciumkörper) abscheiden.

Die weitere polykristalline Schicht wird vorzugsweise durch Abscheidung aus der Gasphase aufgebracht. Hierbei wird in einem Ofen bei Temperaturen über 1000 °C die zu beschichtende polykristalline Schicht auf der Isolierschicht (Keimschicht) einem Gasstrom ausgesetzt, welcher Siliciumatome enthält. Die Siliciumatome werden dabei auf die Keimschicht aufgedampft. Gleichzeitig findet außerdem eine thermische Ausheilung der Keimschicht statt.

Die Isolierschicht besteht entweder aus Siliciumdioxid oder Siliciumnitrid. Das Siliciumdioxid kann durch thermische Oxidation auf dem Siliciumkörper erzeugt werden. Ein Gasstrom, der Sauerstoff und Wasserstoff enthält, strömt in einen Ofen, der auf eine Temperatur von ca. 1000 °C aufgeheizt wurde. In diesem Ofen wächst die Isolierschicht aus Siliciumdioxid auf dem Siliciumkörper auf. Die Isolierschicht aus Siliciumnitrid kann durch Abscheidung aus der Gasphase bei niedrigem Druck (LPCVD) ausgebildet werden.

Die Dotierung der Widerstandsschicht aus polykristallinem Silicium kann durch Ionenimplantation nach dem Aufbringen der weiteren polykristallinen Siliciumschicht erfolgen. Bei diesem Verfahrensschritt werden ionisierte Atome des Dotierstoffes in einem elektrischen Feld beschleunigt und in das Kristallgitter des Siliciums hineingeschossen (implantiert). Anschließend erfolgt eine Rekristallisation bei einer Temperatur zwischen 800 °C und 1200 °C. Als Dotierstoff lassen sich Phosphor, Bor und Arsen verwenden.

Die Dotierung kann auch durch Hinzufügen von Dotierstoffen während des Aufbringens der polykristallinen Siliciumschichten erfolgen.

In einer Weiterbildung des Verfahrens gemäß der Erfindung ist vorgesehen, daß die Widerstandsschicht nach Aufbringen der weiteren polykristallinen Siliciumschicht durch Ätzen strukturiert wird, anschließend eine Passivierungsschicht aufgebracht wird, in die dann durch Photolithographie Fenster für elektrische Kontakte eingebracht werden, und zuletzt eine leitfähige Metallschicht zur Kontaktierung aufgebracht wird.

Die nach dem erfindungsgemäßen Verfahren hergestellte und kontaktierte Widerstandsschicht eignet sich insbesondere zur Verwendung für einen Silicium-Druckaufnehmer, weil sie sich einfach auf den Siliciumkörper aufbringen läßt und eine hohe Dehnungsempfindlichkeit aufweist.

Ein nach insbesondere dem erfindungsgemäßen Verfahren hergestellter Silicium-Druckaufnehmer mit einem, auf einem Träger angebrachten Siliciumkörper, der an seiner dem Träger abgewandten Hauptfläche eine Isolierschicht und einen zum Träger hin geöffneten sacklochartigen, eine Membran bildenden Hohlraum aufweist, auf deren, dem sacklochartigen Hohlraum abgewandten Fläche vier Widerstandelemente angebracht sind, bestehend aus einer halbleitenden, zusätzlich dotierten polykristallinen Widerstandsschicht aus Silicium, einer auf der polykristallinen Widerstandsschicht angebrachten Passivierungsschicht und einer auf der Passivierungsschicht angebrachten, die polykristalline Widerstandsschicht elektrisch kontaktierenden strukturierten Metallschicht, ist dadurch gekennzeichnet, daß die polykristalline Widerstandsschicht aus einer ersten polykristallinen, zusätzlich dotierten Siliciumschicht und einer, in einem nachfolgenden Prozeßschritt auf dieser mit einem gegenüber dem der ersten polykristallinen Siliciumschicht gröberen Kristallitgefüge angebrachten weiteren polykristallinen, zusätzlich dotierten Siliciumschicht besteht.

Vorteilhafte weitere Ausgestaltungen des Silicium-Druckaufnehmers gemäß der Erfindung ergeben sich aus den Unteransprüchen.

Ausführungsbeispiele der Erfindung werden nachstehend anhand der Zeichnungen näher erläutert. Es zeigen:

Fig. 1 eine polykristalline halbleitende Widerstandsschicht aus Silicium auf einen Siliciumkörper,

Fig. 2 eine kontaktierte Widerstandsschicht,

Fig. 3 eine Draufsicht eines Silicium-Druckaufnehmers mit Widerstandsschichten und

Fig. 4 einen Längsschnitt des Druckaufnehmers längs der Ebene II-II der Fig. 3.

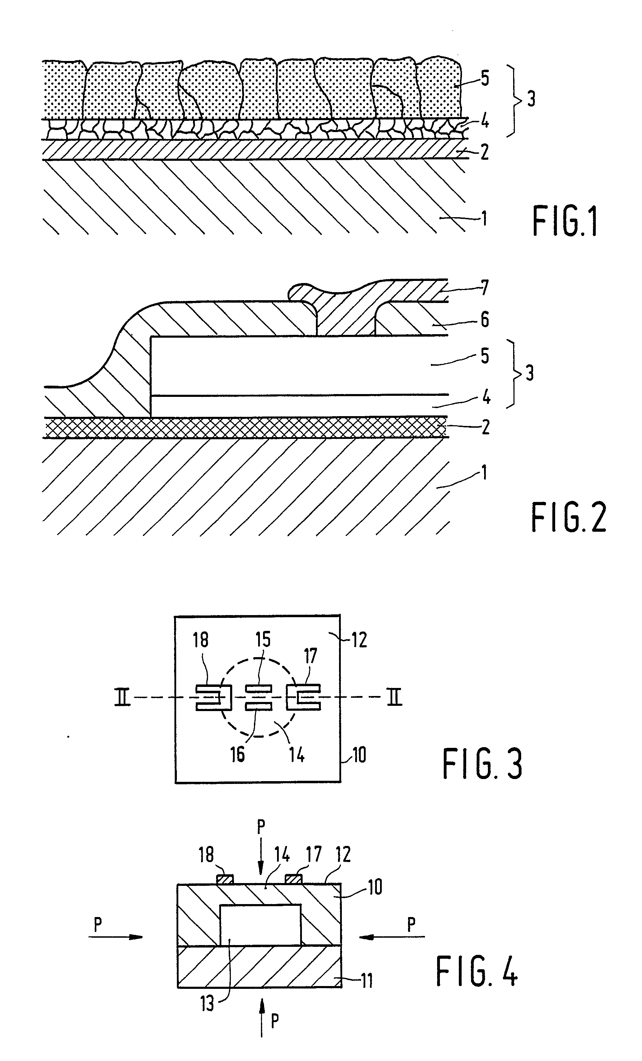

In Fig. 1 ist ein schematischer Querschnitt durch einen Siliciumkörper 1 mit einer Isolierschicht 2 und einer polykristallinen halbleitenden Widerstandsschicht 3 aus Silicium dargestellt. Bei der Herstellung einer solchen polykristallinen Schicht 3 wird zuerst die Isolierschicht 2 auf dem Siliciumkörper 1 durch thermische Oxidation ausgebildet. Der Siliciumkörper 1 wird hierbei in einen Oxidationsofen gelegt, der auf eine Temperatur von ca. 1000 $^\circ$C aufgeheizt worden ist. Ein Gemisch aus Sauerstoff und Wasserstoff strömt ca. eine halbe Stunde in den Ofen hinein. Pro Minute fließen hierbei drei Liter Sauerstoffgas und drei Liter Wasserstoffgas in den Ofen. Nach Abschluß der thermischen Oxidation ist eine 100 nm dicke Schicht 2 aus Siliciumdioxid thermisch aufgewachsen. Es kann auch eine Isolierschicht aus Siliciumnitrid durch die später erläuterte Low Pressure Chemical Vapour Deposition (LPCVD) erzeugt werden.

Im nächsten Verfahrensschritt wird der mit der Isolier-schicht 2 bedeckte Siliciumkörper 1 in einen handelsüblichen Diffusionsofen gebracht und eine erste polykristalline Schicht 4 der Widerstandsschicht 3 durch Low Pressure Chemical Vapour Deposition (LPCVD) auf die Isolierschicht 2 aufgebracht. Der Ofen weist eine Temperatur von 600 $^\circ$C bis 700 $^\circ$C, beispielsweise 610 $^\circ$C, auf. Die zu beschichtende Fläche wird einem Gasstrom ausgesetzt mit einem Trägergas aus Stickstoff und Wasserstoff und einem weiteren Silicium enthaltenden Gas, z.B. Siliciumtetrachlorid ($SiCl_4$) oder Silan ($SiH_4$). Das in dem Gas enthaltene Silicium scheidet sich an der zu beschichtenden Fläche ab. Der Druck liegt bei diesem Prozeß zwischen 0,1 mbar und 0,3 mbar, vorzugsweise bei 0,19 mbar. Die Abscheidung wird erst dann beendet, wenn die polykristalline Schicht 4 als dünne zusammenhängende Schicht die Isolierschicht 2 bedeckt. Die Dicke der Schicht 4 kann beispielsweise 100 nm betragen. Die auf die Isolierschicht 2 aufgebrachte Schicht 4 kann feinkristallin und teilweise auch amorph sein. Sie dient als Keimschicht für eine im nächsten Verfahrensschritt aufzubringende weitere polykristalline Siliciumschicht 5 mit größeren Kristalliten. Die polykristalline Siliciumschicht 4 kann auch mittels Kathodenzerstäubung (Sputtern) erzeugt werden. Die Kathodenzerstäubung ist eine Vakuumbeschichtungsmethode, um ein Substrat (hier: Siliciumkörper 1 mit Isolierschicht 2) mit einer dünnen Schicht (hier: polykristalline Siliciumschicht 4) zu überziehen. Hierbei treffen hochenergetische Edelgasionen im Vakuum auf eine Kathode auf, die aus dem aufzustäubenden Material besteht, und setzen ungeladene Atome oder Moleküle frei, die sich auf dem Siliciumkörper 1 mit Isolierschicht 2 abscheiden. Übliche Verfahren bei der Kathodenzerstäubung sind Ionenstrahlzerstäubung und Plasmazerstäubung.

Nach Aufbringen der polykristallinen Schicht 4 wird der Siliciumkörper 1 in einen Epitaxie-Reaktor gebracht. Der Siliciumkörper 1 wird hierbei in ein Quarzrohr geschoben, das auf eine Temperatur zwischen 1000 $^\circ$C und 1300 $^\circ$C, z.B. 1200 $^\circ$C, aufgeheizt und einem Gasstrom ausgesetzt wird, der als Trägergas Wasserstoff und ein weiteres Gas als Silicium-Quelle enthält, welches beispielsweise aus Siliciumtetrachlorid ($SiCl_4$) oder Silan ($SiH_4$) bestehen kann. Das in dem Gas enthaltene Silicium schlägt sich auf der polykristallinen Siliciumschicht 4 nieder und bildet eine weitere polykristalline Siliciumschicht 5. Der Epitaxieprozeß wird beendet, wenn die Schichtdicke zwischen 300 nm und 1000 nm beträgt. In einem praktischen Ausführungsbeispiel wurde eine Schichtdicke von 700 nm gewählt.

Die polykristalline Siliciumschicht 4, die weitgehend amorph sein kann, wird während dieses epitaktischen Aufwachsens der weiteren polykristallinen Siliciumschicht 5 thermisch ausgeheilt. Es kommt zu einer feinkristallinen Rekristallisation der als Keimschicht wirkenden polykristallinen Siliciumschicht 4. Während der Siliciumabscheidung durch Epitaxie finden die Siliciumatome genügend energetisch günstige Positionen, um sich an Kristallite der polykristallinen Siliciumschicht 4 anzulagern. Hierbei setzen sich nur die bevorzugt wachsenden Orientierungen durch und es entsteht eine polykristalline Siliciumschicht 5 mit einem gröberen kristallinen Gefüge. Der laterale mittlere Korndurchmesser liegt zwischen 1000 nm und 5000 nm.

Die Dotierung der Widerstandsschicht 3 kann auf verschiedene Arten erfolgen. Dotierstoffe können direkt bei dem Aufbringen der polykristallinen Siliciumschichten 4 und 5 hinzugefügt werden. Die Gasströme enthalten dann diese Dotierstoffe.

Eine andere Dotierungsart ist die Ionenimplantation. Bei diesem Verfahrensschritt werden ionisierte Atome des Dotierstoffes in einem elektrischen Feld beschleunigt und in das Kristallgitter des Siliciums hineingeschossen (implantiert). Da durch den Ionenbeschuß das Kristallgitter teilweise zerstört wird, muß anschließend eine Rekristallisation bei einer Temperatur zwischen 500 °C und 1000 °C stattfinden. Als Dotierstoffe werden vorzugsweise Phosphor, Bor und Arsen verwendet. In einem Ausführungsbeispiel wurde als Dotierstoff Bor in einer Konzentration von $8 \times 10^{14}$ cm$^{-2}$ verwendet und bei 1000 °C in Stickstoff getempert.

Ein Maß für die Dehnungsempfindlichkeit eines Widerstandes R ist sein k-Faktor, der die relative Widerstandsänderung dR/R je Dehnung e angibt: dR/R = k e.

Nach dem erfindungsgemäßen Verfahren hergestellte Widerstandsschichten weisen einen k-Faktor zwischen 43 und 52 auf. Die nach dem Ausführungsbeispiel hergestellte Widerstandsschicht 3 weist einen k-Faktor von 52, einen spezifischen Widerstand von 24 m Ohm/cm, einen Temperaturkoeffzienten des Widerstandes von - 0,01 %/K auf. Der Temperaturkoeffizient des k-Faktors beträgt - 0,15 %/K.

Zur Kontaktierung der Widerstandsschicht 3 wird zuerst durch thermische Oxidation eine Passivierungsschicht 6, beispielsweise aus Siliciumnitrid oder Siliciumdioxid, aufgebracht. In einem üblichen photolithographischen Verfahrensschritt werden anschließend Fenster in die Passivierungsschicht 6 eingebracht und dann eine elektrisch leitfähige Metallschicht 7, beispielsweise aus Aluminium, aufgedampft. Diese Metallschicht 7 kontaktiert die Widerstandsschicht 3. Sie läßt sich ebenfalls photolithographisch strukturieren.

Die nach dem erfindungsgemäßen Verfahren hergestellte Widerstandsschicht 3 eignet sich insbesondere zur Verwendung für einen Silicium-Druckaufnehmer. Ein solcher Silicium-Druckaufnehmer ist in den Fig. 3 und 4 dargestellt. Dieser Druckaufnehmer enthält einen quaderförmigen Siliciumkörper 10, der beispielsweise durch anodisches Bonden mit einem Träger 11 kontaktiert wird. Der Träger 11 kann beispielsweise eine Glasplatte sein. Im Siliciumkörper 10 ist ein sacklochartiger Hohlraum 13 vorhanden, der einen kreisförmigen Querschnitt hat und zum Träger 11 hin geöffnet ist. Aufgrund dieses Hohlraumes 13 bildet sich eine kreisförmige Membran 14, auf der vier Widerstandselemente 15 bis 18 angeordnet sind.

Die Widerstandselemente 15 und 16 sind als parallele Längsstreifen im Zentrum der Membran 14 angeordnet. Die Widerstandselemente 17 und 18 sind als U-förmige Streifen ausgebildet und am Außenrand der Membran 14 diametral gegenüberliegend so angeordnet, daß die Öffnungen der U-förmigen Streifen in Richtung auf die Außenkante des Siliciumkörpers 10 weisen. Die U-förmigen Öffnungen der Widerstandselemente 17 und 18 könnten auch in Richtung auf die Membran 14 zeigen. Die vier Widerstandselemente 15 bis 18 bestehen aus den polykristallinen die Widerstandsschicht 3 bildenden Siliciumschichten 4 und 5 und sind nach dem vorher geschilderten Verfahren auf den Siliciumkörper 10 aufgebracht worden.

Die nach dem erfindungsgemäßen Verfahren hergestellte polykristalline Silicium-Schichtenfolge ist auch für die Herstellung von Halbleiterbauelementen einsetzbar. Überall dort, wo mittels Laserstrahl rekristallisierte Schichten eingesetzt werden oder in Betracht zu ziehen sind, könnten nach dem vorliegenden Verfahren hergestellte polykristalline Schichten eingesetzt werden, z.B. bei der Herstellung von Dünnschichttransistoren auf Quarzsubstraten.

## Ansprüche

1. Verfahren zur Herstellung einer polykristallinen halbleitenden Widerstandsschicht aus Silicium auf einem Siliciumkörper, bei dem zuerst eine Isolierschicht auf dem Siliciumkörper erzeugt und anschließend eine polykristalline Siliciumschicht abgeschieden wird, die zusätzlich dotiert wird, dadurch gekennzeichnet, daß auf die abgeschiedene polykristalline Siliciumschicht (erste polykristalline Siliciumschicht) eine weitere polykristalline zu dotierende Siliciumschicht mit einem gegenüber dem der ersten polykristallinen Siliciumschicht gröberen Kristallitgefüge aufgebracht wird.

2. Verfahren nach Anspruch 1,
dadurch gekennzeichnet, daß die erste polykristalline Siliciumschicht auf der Isolierschicht mittels Chemical oder Physical Vapour Deposition abgeschieden wird.

3. Verfahren nach Anspruch 2,
dadurch gekennzeichnet, daß die erste polykristalline Siliciumschicht auf der Isolierschicht mittels Chemical Vapour Deposition bei niedrigem Druck (LPCVD) abgeschieden wird.

4. Verfahren nach Anspruch 3,
dadurch gekennzeichnet, daß die Abscheidung bei einem Druck zwischen 0,1 mbar und 0,3 mbar erfolgt.

5. Verfahren nach Anspruch 2,
dadurch gekennzeichnet, daß die erste polykristalline Siliciumschicht auf der Isolierschicht mittels Kathodenzerstäubung abgeschieden wird.

6. Verfahren nach mindestens einem der Ansprüche 1 bis 5,
dadurch gekennzeichnet, daß die Abscheidung der ersten polykristallinen Siliciumschicht frühestens beendet wird, wenn sich eine dünne zusammenhängende Schicht ausgebildet hat.

7. Verfahren nach mindestens einem der Ansprüche 1 bis 6,
dadurch gekennzeichnet, daß die weitere polykristalline Siliciumschicht (5) durch Abscheidung aus der Gasphase aufgebracht wird.

8. Verfahren nach mindestens einem der Ansprüche 1 bis 7, dadurch gekennzeichnet, daß eine Siliciumdioxidschicht durch thermische Oxidation auf dem Siliciumkörper als Isolierschicht erzeugt wird.

9. Verfahren nach mindestens einem der Ansprüche 1 bis 7,
dadurch gekennzeichnet, daß eine Siliciumnitridschicht durch Low Pressure Chemical Deposition (LPCVD) auf dem Siliciumkörper als Isolierschicht abgeschieden wird.

10. Verfahren nach mindestens einem der Ansprüche 1 bis 9,
dadurch gekennzeichnet, daß durch Ionenimplantation dotiert wird.

11. Verfahren nach mindestens einem der Ansprüche 1 bis 9,
dadurch gekennzeichnet, daß durch Hinzufügen von Dotierstoffen während des Aufbringens der polykristallinen Siliciumschichten dotiert wird.

12. Verfahren nach mindestens einem einem der Ansprüche 1 bis 11,
dadurch gekennzeichnet, daß die Widerstandsschicht nach Aufbringen der weiteren polykristallinen Siliciumschicht durch Ätzen strukturiert wird, anschließend eine Passivierungsschicht aufgebracht wird, in die dann durch Photolithographie Fenster für elektrische Kontakte eingebracht werden, und zuletzt eine leitfähige Metallschicht zur Kontaktierung aufgebracht wird.

13. Verwendung einer Widerstandsschicht nach den Ansprüchen 1 bis 12 für einen Silicium-Druckaufnehmer.

14. Silicium-Druckaufnehmer, hergestellt unter Anwendung des Verfahrens insbesondere nach den Ansprüchen 1 bis 12, mit einem, auf einem Träger angebrachten Siliciumkörper, der an seiner dem Träger abgewandten Hauptfläche eine Isolierschicht und einen zum Träger hin geöffneten sacklochartigen, eine Membran bildenden Hohlraum aufweist, auf deren, dem sacklochartigen Hohlraum abgewandten Fläche vier Widerstandselemente angebracht sind, bestehend aus einer halbleitenden zusätzlich dotierten polykristallinen Widerstandsschicht aus Silicium, einer auf der polykristallinen Widerstandsschicht angebrachten Passivierungsschicht und einer auf der Passivierungsschicht angebrachten, die polykristalline Widerstandsschicht elektrisch kontaktierenden strukturierten Metallschicht,
dadurch gekennzeichnet,
daß die polykristalline Widerstandsschicht (3) aus einer ersten polykristallinen, zusätzlich dotierten Silicium schicht (4) und einer, in einem nachfolgenden Prozeßschritt auf dieser mit einem gegenüber dem der ersten polykristallinen Siliciumschicht gröberen Kristallitgefüge angebrachten weiteren polykristallinen, zusätzlich dotierten Siliciumschicht (5) besteht.

15. Silicium-Druckaufnehmer nach Anspruch 14,
dadurch gekennzeichnet,
daß der Siliciumkörper (10) quaderförmig ist.

16. Silicium-Druckaufnehmer nach Anspruch 15,
dadurch gekennzeichnet,
daß die mit Hilfe des sacklochartigen Hohlraums (13) im Siliciumkörper (10) gebildete Membran (14) kreisförmig ist.

17. Silicium-Druckaufnehmer nach mindestens einem der Ansprüche 14 bis 16,
dadurch gekennzeichnet,
daß die Widerstandselemente (15, 16, 17, 18) paarweise eine unterschiedliche geometrische Form haben, wobei jeweils zwei einander diametral gegenüberliegende Widerstandselemente (15 und 16) oder (17 und 18) sich in ihrer geometrischen Form entsprechen.

18. Silicium-Druckaufnehmer nach Anspruch 17,
dadurch gekennzeichnet,
daß ein Paar Widerstandselemente (15 und 16) als parallele Längsstreifen im Zentrum der Membran (14) angeordnet ist.

19. Silicium-Druckaufnehmer nach Anspruch 17,
dadurch gekennzeichnet,
daß das andere Paar Widerstandselemente (17 und 18) als U-förmige Streifen ausgebildet und am Außenrand der Membran (14) so angeordnet ist, daß die Schenkel der U-förmigen Streifen entweder in Richtung auf die Außenkante des Siliciumkörpers (10) oder in Richtung auf das Zentrum der Membran (14) weisen.

20. Silicium-Druckaufnehmer nach mindestens einem der Ansprüche 14 bis 19,
dadurch gekennzeichnet,
daß die erste polykristalline Siliciumschicht (4) eine mittels Chemical Vapour Deposition insbesondere bei niedrigem Druck (LPCVD) abgeschiedene Schicht ist.

21. Silicium-Druckaufnehmer nach mindestens einem der Ansprüche 14 bis 19,
dadurch gekennzeichnet,
daß die erste polykristalline Siliciumschicht (4) eine durch Kathodenzerstäubung abgeschiedene Schicht ist.

22. Silicium-Druckaufnehmer nach mindestens einem der Ansprüche 14 bis 21,
dadurch gekennzeichnet,
daß die weitere polykristalline Siliciumschicht (5) eine aus der Gasphase abgeschiedene Schicht mit Kristalliten eines mittleren lateralen Korndurchmessers im Bereich von 1000 nm bis 5000 nm ist.

23. Silicium-Druckaufnehmer nach mindestens einem der Ansprüche 14 bis 22,
dadurch gekennzeichnet,
daß die erste polykristalline Siliciumschicht (4) mindestens eine solche Schichtdicke hat, daß eine zusammenhängende Schicht ausgebildet ist und daß sie vorzugsweise eine Schichtdicke von etwa 100 nm hat.

24. Silicium-Druckaufnehmer nach mindestens einem der Ansprüche 14 bis 23,
dadurch gekennzeichnet,
daß die weitere polykristalline Siliciumschicht (5) eine Dicke im Bereich von 300 nm bis 1000 nm hat.

25. Silicium-Druckaufnehmer nach mindestens einem der Ansprüche 14 bis 24,
dadurch gekennzeichnet,
daß der Siliciumkörper (10) durch anodisches Bonden mit dem Träger (11) fest verbunden ist.

26. Silicium-Druckaufnehmer nach Anspruch 25,
dadurch gekennzeichnet,
daß der Träger (11) eine Glasplatte ist.

27. Silicium-Druckaufnehmer nach mindestens einem der Ansprüche 14 bis 26,
dadurch gekennzeichnet,

daß die die Widerstandsschicht (3) elektrisch kontaktierende Metallschicht (7) aus Aluminium besteht.

28. Silicium-Druckaufnehmer nach mindestens einem der Ansprüche 14 bis 27,
dadurch gekennzeichnet,
daß die Isolierschicht (2) und die Passivierungsschicht (6) durch thermische Oxidation des Siliciumkörpers (10) gebildete Oxidschichten sind.

29. Silicium-Druckaufnehmer nach mindestens einem der Ansprüche 14 bis 27,
dadurch gekennzeichnet,
daß die Isolierschicht (2) und die Passivierungsschicht (6) Siliciumnitridschichten sind.

FIG.1

FIG.2

FIG.3

FIG.4